# EUROPEAN PATENT SPECIFICATION

(11) **EP 4 222 512 B1**
(45) Date of publication and mention of the grant of the patent: **17.07.2024**
(21) Application number: 21773413.6
(22) Date of filing: 14.09.2021
(51) Int. Cl.: G01R 31/34

(54) **CONNECTING DEVICE FOR ELECTRIC MOTOR TESTING AND ELECTRIC MOTOR TESTING DEVICE**
ANSCHLUSSVORRICHTUNG ZUR PRÜFUNG VON ELEKTROMOTOREN UND PRÜFVORRICHTUNG FÜR ELEKTROMOTOREN
DISPOSITIF DE LIAISON DE TEST DE MOTEUR ÉLECTRIQUE ET DISPOSITIF DE TEST DE MOTEUR ÉLECTRIQUE

(30) Priority: 29.09.2020 CN 202011049579
(43) Date of publication of application: 09.08.2023
(73) Proprietor: ZF Friedrichshafen AG, 88046 Friedrichshafen (DE)
(72) Inventor: SI, Xiang, Shanghai (CN)
(86) International application number: PCT/EP2021/075231
(87) International publication number: WO 2022/069216

(56) References cited:
- CN-A- 102 928 780
- CN-B- 103 149 480
- CN-B- 106 324 500
- CN-U- 205 038 315

## Description

### Technical Field

The present invention relates to a connecting device for electric motor testing and an electric motor testing device.

### Background Art

In the field of electric motor testing, the performance of electric motors in different temperature ranges needs to be tested. For small electric motors, it is particularly difficult to test their performance in different temperature ranges in which their torque output is small.

In the prior art, an electric motor to be tested is generally placed in a thermostat such that the electric motor is at a set ambient temperature, the electric motor is then taken out for measuring the performance of the electric motor as the performance of the electric motor at the set ambient temperature. Since it is difficult for the electric motor taken out to maintain the ambient temperature set in the thermostat at room temperature, the accuracy of a test result cannot be achieved.

If the electric motor is not taken out from the thermostat in order to simulate the ambient temperature of the electric motor in real time, an output shaft of the electric motor cannot be directly connected to electric motor testing equipment outside the thermostat due to the length limitation of the output shaft of the electric motor. If the output shaft is designed to be very long, the output shaft of the electric motor may be susceptible to tip shaking, which will influence the test result. In addition, if the output shaft is directly connected to the external testing equipment, contact friction will be formed between the output shaft and the wall of the thermostat, which would also influences the accuracy of the test result.

CN 102 928 780 A discloses an anechoic chamber, an analog load chamber, a drive shaft, a waveguide, a shielding guard, and an anechoic chamber test bench for placing a high-power motor, the dynamometer being placed in an analog load chamber adjacent to the anechoic chamber, both passing through the transmission shaft of the shielding chamber of the anechoic chamber is connected, the waveguide is installed outside the transmission shaft, and the shielding protection device is installed on both sides of the waveguide; a common wall is defined between the anechoic chamber and the simulated load chamber, and a through hole is defined therein, and the transmission shaft and the waveguide are connected to the dynamometer in the simulated load chamber through the hole; a middle portion of the transmission shaft is provided with a section of non-metallic transmission shaft; the material of the non-metal transmission shaft is carbon fiber.

It is apparent that the structure for testing the electric motor in the prior art may not obtain an accurate test result of the electric motor performance at a certain constant ambient temperature.

### Summary of the Invention

For solving the technical problem, the present invention aims to overcome the defect in the prior art that a device for testing an electric motor cannot ensure the accuracy of a test result of electric motor performance at constant ambient temperature, and to provide a novel connecting device for electric motor testing and an electric motor testing device.

The present invention solves the technical problem by the following technical solution:
a connecting device for electric motor testing, wherein an electric motor to be tested is placed in a thermostat, the connecting device penetrates a side wall of the thermostat and comprises a housing, a connecting shaft and at least two seals,
the connecting shaft comprises a first section, a second section, and an intermediate section located between the first section and the second section, and the first section, the second section and the intermediate section are integrally formed.

The intermediate section is located in the housing, and the first section and the second section are located outside the housing.

The at least two seals are sleeved on an outer peripheral wall of the intermediate section and are in tight fit with the housing, and at least one sealed cavity is enclosed together by the at least two seals, the outer peripheral wall of the intermediate section and an inner wall of the housing, and is filled with compressed air to support the connecting shaft.

The first section is connected to a piece of external electric motor testing equipment outside a thermostat, and the second section is connected to the electric motor inside the thermostat.

Preferably, the intermediate section is provided with a protrusion for preventing the connecting shaft from moving axially.

Preferably, the protrusion is integrally formed with the connecting shaft and is close to the first section.

Preferably, the number of the seals is four, and the four seals are respectively sleeved on the outer peripheral walls of two ends of the intermediate section.

Preferably, the inner wall of the housing is provided with a recess, the recess, the at least two seals and the outer peripheral wall of the intermediate section together forming the at least one sealed cavity.

Preferably, the connecting device further comprises a thermostatic structure, the thermostatic structure comprising a fluid inflow passage and a fluid outflow passage provided in a main body of the housing, and a bushing located inside the sealed cavity, at least part of the sealed cavity being covered by a space region formed by the thickness of the side wall, the fluid inflow passage being in communication with one end of the bushing, and the other end of the bushing being in communication with the fluid outflow passage.

Preferably, the bushing is sleeved on the periphery of the intermediate section and is in tight fit with the housing, and an outer surface of the bushing is provided with a flow channel for fluid to flow therethrough.

Preferably, the flow channel is a spiral flow channel.

Preferably, the housing comprises a main body, a left end cap and a right end cap, wherein the left end cap is fixedly connected to the main body, the right end cap is fixedly connected to the main body, the left end cap is located inside the thermostat, and the right end cap is located outside the thermostat, and
the second section extends beyond the left end cap, and the first section extends beyond the right end cap.

Preferably, lubricating grease is provided in a hole of the left end cap for the second section to extend therefrom, and lubricating grease is provided in a hole of the right end cap for the first section to extend therefrom.

An electric motor testing device comprises a thermostat, a torque sensor, a servo electric motor, and the connecting device as mentioned above, wherein
an electric motor to be tested is placed in the thermostat, and an output shaft of the electric motor to be tested is connected to the second section of the connecting shaft of the connecting device,
a side wall of the thermostat is provided with a through hole, the housing of the connecting device passing through the through hole and being sealed against an inner wall of the through hole, and
the first section of the connecting shaft is connected to the torque sensor, and the torque sensor is connected to the servo electric motor.

Preferably, a rubber sleeve is arranged on the inner wall of the through hole, and the housing is sealed against the inner wall of the through hole by means of the rubber sleeve.

The technical effects obtained by the present invention are as follows: the electric motor to be tested in the thermostat is connected to the external electric motor testing equipment by means of the connecting device, such that it can be ensured in real time that the electric motor to be tested has multiple constant ambient temperature values, and the performance of the electric motor at different ambient temperatures can be measured in real time; moreover, the connecting device can directly transfer a torque from the output shaft of the electric motor to the electric motor testing equipment through the connecting shaft, avoiding energy loss caused by frictional contact with the connecting shaft, and making the test result of the electric motor more accurate. The accuracy of a test result can be ensured at constant ambient temperature.

### Brief Description of the Drawings

Fig. 1 is a simplified structural schematic diagram of an electric motor testing device of embodiment 1 of the present invention.
Fig. 2 is a structural schematic diagram of a connecting device of embodiment 1 of the present invention.

List of reference numerals:
thermostat 1, connecting device 2, torque sensor 3, servo electric motor 4, electric motor to be tested 5, coupling 6,
side wall 11, through hole 12, rubber sleeve 13,
housing 21, connecting shaft 22, seal 23, sealed cavity 24, bushing 25,
main body 210, left end cap 211, right end cap 212, fluid inflow passage 213, fluid outflow passage 214,
first section 221, second section 222, intermediate section 223, protrusion 224, and
flow passage 251.

### Detailed Description of Embodiments

The present invention will be described more clearly and completely hereinafter according to a preferred embodiment of the present invention and with reference to the accompanying drawings.

### Embodiment 1

This embodiment provides an electric motor testing device which is suitable for testing various types of electric motors, including a large electric motor and a small electric motor, and is particularly suitable for testing the performance of an electric motor where its torque is less than 0.1Nm. The testing device can test parameters of the electric motor, such as torque, rotational speed, current and internal resistance.

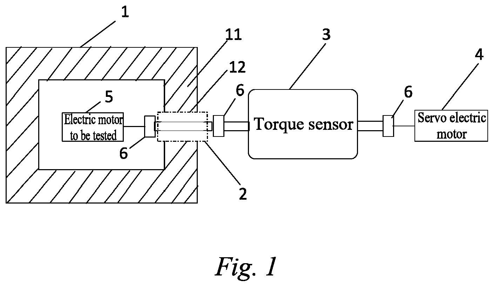

As shown in Fig. 1, the testing device comprises a thermostat 1, a connecting device 2, a torque sensor 3 and a servo electric motor 4.

An electric motor to be tested 5 is placed in the thermostat 1, and the thermostat is capable of providing a wide range of adjustable ambient temperatures, such as from -40 degrees to 150 degrees, for the electric motor to be tested. A side wall 11 of the thermostat 1 is provided with a through hole 12, the electric motor to be tested 5 passes through the through hole 12 by virtue of the connecting device 2 and is connected to the torque sensor 3 outside the thermostat 1, and the torque sensor 3 is connected to the servo electric motor 4. Optionally, the testing device further comprises one or more couplings 6, respective connection between the electric motor to be tested 5, the connecting device 2, the torque sensor 3 and the servo electric motor 4 are enabled by the couplings 6.

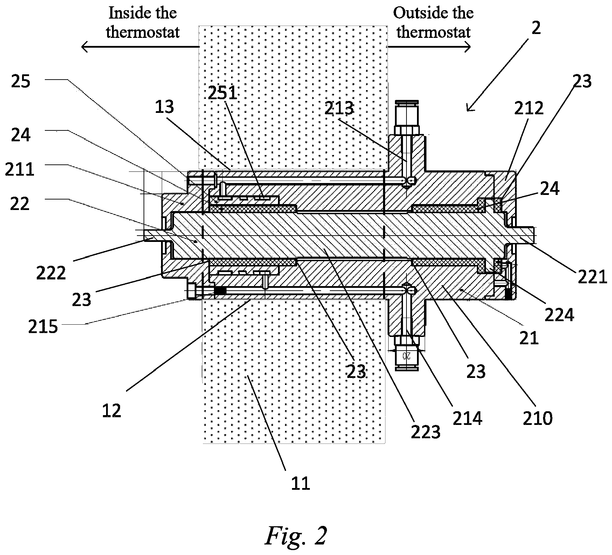

Fig. 2 specifically shows the connecting device 2 comprising a housing 21, a connecting shaft 22 and at least two seals 23. In a preferred embodiment, the number of seals is 4, namely, two pairs of seals.

The connecting shaft 22 comprises a first section 221, a second section 222, and an intermediate section 223 located between the first section and the second section, the first section 221, the second section 222, and the intermediate section 223 being integrally formed.

The portion of the connecting shaft connected to electric motor testing equipment outside the thermostat is the first section 221, and the portion of the connecting shaft connected to the electric motor inside the thermostat is the second section 222.

Preferably, the intermediate section 223 is provided with a protrusion 224, the protrusion 224 being used for preventing the connecting shaft 22 from moving axially. The protrusion 224 is located on the one of two ends of the intermediate section 223 close to the first section 221. The protrusion may be disposed in such a manner as to be integrally formed with the connecting shaft to simplify the structure.

The intermediate section 223 is located inside the housing 21, and the first section 221 and the second section 222 are located outside the housing 21.

The two pairs of seals 23 are respectively sleeved on the outer peripheral walls of the two ends of the intermediate section 223 and are in tight fit with the housing 21, wherein a respective sealed cavity 24 is enclosed together by each pair of seals 23, the outer peripheral wall of the intermediate section 223 and the inner wall of the housing 21, and the two sealed cavities 24 are filled with compressed air to support the connecting shaft 22.

The two sealed cavities 24 can better achieve the balance of support for the connecting shaft and allow a more stable support.

Since the connecting shaft is supported by means of the sealed cavities filled with the compressed air, and the sealed cavities are in contact with the outer peripheral wall of the intermediate section only by means of the compressed air and have no large-area physical contact with the outer peripheral wall of the intermediate section, physical contact with the outer peripheral wall of the connecting shaft, which is caused where the connecting shaft is supported by using other hardware, is avoided, and frictional loss caused by the physical contact when the power from an output shaft of the electric motor is transferred to the connecting shaft is then avoided. As can be seen, the power is transferred without loss to the torque sensor by means of the connecting shaft 22, which improves the accuracy of the test result. Compared with a means in which an additional part is further provided on the basis of the housing and the connecting shaft to support the connecting shaft, the sealed cavities are formed directly by the inner wall of the housing, the outer peripheral wall of the connecting shaft and the seals in the embodiment and the connecting shaft is supported by the pressurized sealed cavities, thereby eliminating additional support parts, improving the integration level of the parts, and saving on mounting space.

Preferably, a recess (not shown) may also be provided in the inner wall of the housing, the seals are mounted in the recess, and closed spaces formed by the recess, the two seals and the outer peripheral wall of the connecting shaft serve as the sealed cavities. In this way, the volume of the sealed cavity can be increased, which is beneficial to improvement of the support effect on the connecting shaft.

Furthermore, the housing 21 of the connecting device 2 passes through the through hole 12 and is sealed against an inner wall of the through hole 12. A rubber sleeve 13 is arranged on the inner wall of the through hole 12, and the housing 21 is sealed against the inner wall of the through hole 12 by means of the rubber sleeve 13.

The arrangement of the rubber sleeve 13 can adaptively match a connection gap between the housing 21 and the through hole 12. By merely adjusting the size of the rubber sleeve 13, housings of different sizes can pass through the through hole to create a good seal without changing the size of the housing, making the testing more convenient.

The housing 21 is configured to be a three-section structure which can facilitate dismounting and mounting. Specifically, the housing 21 comprises a main body 210, a left end cap 211 and a right end cap 212, wherein the left end cap 211 may be fixedly connected to the main body 210, for example, by a bolt 215, and the right end cap 212 may be fixedly connected to the main body 210 , for example, by a bolt.

The left end cap 211 is located inside the thermostat 1, and the right end cap 212 is located outside the thermostat 1. The second section 222 extends beyond the left end cap 211, and the first section 221 extends beyond the right cap 212. In addition, lubricating grease may be provided in a through hole of the left end cap 211 for the second section to extend therefrom, and lubricating grease may also be provided in a through hole of the right end cap 211 for the first section to extend therefrom, in order to prevent circulation of air without a pressure difference between the inside of the housing and the outside of the housing.

By arranging the connecting shaft 22 inside the closed housing, friction caused by direct contact with the wall of the thermostat when the connecting shaft passes through the wall of the thermostat is avoided, and the accuracy of the test result is ensured.

In order to prevent the compressed air in the sealed cavities in the housing from being influenced by the temperature in the thermostat, a thermostatic structure may further be arranged in the connecting device, such that the compressed air in the sealed cavities in the space range covered by the thickness of the side wall of the thermostat is kept at constant temperature. In other words, the thermostatic structure is suitable for the sealed cavity in the extent of the through hole for the wall of the thermostat, and the sealed cavity outside the extent of the through hole for the wall of the thermostat may not use the thermostatic structure because the sealed cavity is in room-temperature environment. The implementation may be as follows:
a fluid inflow passage 213 and a fluid outflow passage 214 are provided in the main body 210 of the housing 21.

Furthermore, the connecting device 2 further comprises a bushing 25, the bushing 25 being located in the sealed cavity 24.

The fluid inflow passage 213 is in communication with one end of the bushing, and the other end of the bushing is in communication with the fluid outflow passage 214.

Preferably, the bushing 25 is sleeved on the periphery of the intermediate section 223, and the bushing 25 is in tight fit with the housing 21. An outer surface of the bushing 25 is provided with a flow channel 251, and the flow channel 251 may be in the form of a spiral flow channel, such as a spiral groove.

A fluid is injected into the fluid inflow passage 213 and may be liquid or gas, and compressed gas may be introduced to increase a flow rate. Water flows into the bushing 25, through the spiral flow channel 251 in the bushing 25 and then flows out of the fluid outflow passage 214, such that the compressed air in the sealed cavity can be kept at constant temperature without being influenced by the thermostat, and thus the support for the connecting shaft is not influenced.

The test of the performance of the electric motor in the prior art is optimized by the connecting device of this embodiment, and the accuracy of the test result of the electric motor at different ambient temperatures can be ensured.

Although the specific embodiments of the present invention are described above, it should be appreciated by those skilled in the art that these are merely illustrative and that the scope of protection of the present invention is defined by the appended claims. Various changes or modifications to these embodiments may be made by those skilled in the art without departing from the scope of the present invention.

## Claims

1. A connecting device (2) for electric motor testing, **characterized in that** an electric motor (5) to be tested is placed in a thermostat (1), the connecting device penetrates a side wall of the thermostat and comprises a housing (21), a connecting shaft and at least two seals,
the connecting shaft (22) comprises a first section (221), a second section (222), and an intermediate section (223) located between the first section and the second section, the first section, the second section and the intermediate section are integrally formed,
the intermediate section is located inside the housing, and the first section and the second section are located outside the housing;
the at least two seals are sleeved on an outer peripheral wall of the intermediate section and are in tight fit with the housing, and at least one sealed cavity is enclosed together by the at least two seals (23), the outer peripheral wall of the intermediate section and an inner wall of the housing, and is filled with compressed air to support the connecting shaft; and
the first section is connected to a piece of external electric motor testing equipment outside a thermostat, and the second section is connected to the electric motor inside the thermostat.

2. The connecting device of claim 1, **characterized in that** the intermediate section is provided with a protrusion (224) for preventing the connecting shaft from moving axially.

3. The connecting device of claim 2, **characterized in that** the protrusion is integrally formed with the connecting shaft and is close to the first section.

4. The connecting device of claim 1, **characterized in that** the number of the seals is four, and the four seals are respectively sleeved on the outer peripheral walls of two ends of the intermediate section.

5. The connecting device of claim 1, **characterized in that** the inner wall of the housing is provided with a recess, the recess, the at least two seals and the outer peripheral wall of the intermediate section together forming the at least one sealed cavity (24).

6. The connecting device of claim 1, **characterized in that** the connecting device further comprises a thermostatic structure, the thermostatic structure comprising a fluid inflow passage (213) and a fluid outflow passage (214) provided in a main body of the housing, and a bushing (25) located inside the sealed cavity, at least part of the sealed cavity being covered by a space region formed by the thickness of the side wall, the fluid inflow passage being in communication with one end of the bushing, and the other end of the bushing being in communication with the fluid outflow passage.

7. The connecting device of claim 6, **characterized in that** the bushing is sleeved on the periphery of the intermediate section and is in tight fit with the housing, and an outer surface of the bushing is provided with a flow channel (251) for fluid to flow therethrough.

8. The connecting device of claim 7, **characterized in that** the flow channel is a spiral flow channel.

9. The connecting device of any one of claims 1-8, **characterized in that** the housing comprises a main body (210), a left end cap (211) and a right end cap (212), wherein the left end cap is fixedly connected to the main body, the right end cap is fixedly connected to the main body, the left end cap is located inside the thermostat, and the right end cap is located outside the thermostat, and
the second section extends beyond the left end cap, and the first section extends beyond the right end cap.

10. The connecting device of claim 9, **characterized in that** lubricating grease is provided in a hole of the left end cap for the second section to extend therefrom, and lubricating grease is provided in a hole of the right end cap for the first section to extend therefrom.

11. An electric motor testing device, **characterized by** comprising a thermostat, a torque sensor, a servo electric motor, and a connecting device of any one of claims 1-10, wherein
an electric motor to be tested is placed in the thermostat, and an output shaft of the electric motor to be tested is connected to the second section of the connecting shaft of the connecting device,
a side wall (11) of the thermostat is provided with a through hole, the housing of the connecting device passing through the through hole and being sealed against an inner wall of the through hole, and
the first section of the connecting shaft is connected to the torque sensor, and the torque sensor is connected to the servo electric motor.

12. The electric motor testing device of claim 11, **characterized in that** a rubber sleeve is arranged on the inner wall of the through hole, and the housing is sealed against the inner wall of the through hole by means of the rubber sleeve.

## Patentansprüche

1. Verbindungsvorrichtung (2) für eine Elektromotorprüfung, **dadurch gekennzeichnet, dass** ein zu prüfender Elektromotor (5) in einem Thermostat (1) platziert wird,
wobei die Verbindungsvorrichtung eine Seitenwand des Thermostats durchdringt und ein Gehäuse (21), eine Verbindungswelle und mindestens zwei Dichtungen umfasst,
wobei die Verbindungswelle (22) einen ersten Abschnitt (221), einen zweiten Abschnitt (222) und einen dazwischenliegenden Abschnitt (223), der sich zwischen dem ersten Abschnitt und dem zweiten Abschnitt befindet, umfasst, wobei der erste Abschnitt, der zweite Abschnitt und der dazwischenliegende Abschnitt integral ausgebildet sind,
wobei sich der dazwischenliegende Abschnitt innerhalb des Gehäuses befindet und sich der erste Abschnitt und der zweite Abschnitt außerhalb des Gehäuses befinden;
wobei die mindestens zwei Dichtungen auf eine Außenumfangswand des dazwischenliegenden Abschnitts aufgeschoben sind und in einem Presssitz mit dem Gehäuse stehen, und wobei mindestens ein abgedichteter Hohlraum durch die mindestens zwei Dichtungen (23), die Außenumfangswand des dazwischenliegenden Abschnitts und eine Innenwand des Gehäuses gemeinsam umschlossen wird und mit Druckluft zum Stützen der Verbindungswelle gefüllt ist; und
wobei der erste Abschnitt mit einem Teil einer externen Elektromotorprüfausrüstung außerhalb eines Thermostats verbunden ist und der zweite Abschnitt mit dem Elektromotor innerhalb des Thermostats verbunden ist.

2. Verbindungsvorrichtung nach Anspruch 1, **dadurch gekennzeichnet, dass** der dazwischenliegende Abschnitt mit einem Vorsprung (224) zum Verhindern einer axialen Bewegung der Verbindungswelle versehen ist.

3. Verbindungsvorrichtung nach Anspruch 2, **dadurch gekennzeichnet, dass** der Vorsprung mit der Verbindungswelle integral ausgebildet ist und sich in der Nähe des ersten Abschnitts befindet.

4. Verbindungsvorrichtung nach Anspruch 1, **dadurch gekennzeichnet, dass** die Anzahl der Dichtungen vier ist und die vier Dichtungen jeweils auf die Außenumfangswände von zwei Enden des dazwischenliegenden Abschnitts aufgeschoben sind.

5. Verbindungsvorrichtung nach Anspruch 1, **dadurch gekennzeichnet, dass** die Innenwand des Gehäuses mit einer Aussparung versehen ist, wobei die Aussparung, die mindestens zwei Dichtungen und die Außenumfangswand des dazwischenliegenden Abschnitts gemeinsam den mindestens einen abgedichteten Hohlraum (24) bilden.

6. Verbindungsvorrichtung nach Anspruch 1, **dadurch gekennzeichnet, dass** die Verbindungsvorrichtung ferner eine Thermostatstruktur, wobei die Thermostatstruktur einen Fluidzulaufkanal (213) und einen Fluidablaufkanal (214) umfasst, die in einem Hauptkörper des Gehäuses bereitgestellt sind, und eine Durchführung (25), die sich innerhalb des abgedichteten Hohlraums befindet, umfasst, wobei zumindest ein Teil des abgedichteten Hohlraums durch einen Raumbereich abgedeckt ist, der durch die Dicke der Seitenwand gebildet ist, wobei der Fluidzulaufkanal mit einem Ende der Durchführung in Verbindung steht und das andere Ende der Durchführung mit dem Fluidablaufkanal in Verbindung steht.

7. Verbindungsvorrichtung nach Anspruch 6, **dadurch gekennzeichnet, dass** die Durchführung auf den Umfang des dazwischenliegenden Abschnitts aufgeschoben ist und in einem Presssitz mit dem Gehäuse steht, und eine Außenfläche der Durchführung mit einem Strömungskanal (251) zum Strömen von Fluid dort hindurch versehen ist.

8. Verbindungsvorrichtung nach Anspruch 7, **dadurch gekennzeichnet, dass** der Strömungskanal ein spiralförmiger Strömungskanal ist.

9. Verbindungsvorrichtung nach einem der Ansprüche 1-8, **dadurch gekennzeichnet, dass** das Gehäuse einen Hauptkörper (210), eine linke Endkappe (211) und eine rechte Endkappe (212) umfasst,
wobei die linke Endkappe fest mit dem Hauptkörper verbunden ist, die rechte Endkappe fest mit dem Hauptkörper verbunden ist, sich die linke Endkappe innerhalb des Thermostats befindet und sich die rechte Endkappe außerhalb des Thermostats befindet, und
wobei sich der zweite Abschnitt über die linke Endkappe hinaus erstreckt und sich der erste Abschnitt über die rechte Endkappe hinaus erstreckt.

10. Verbindungsvorrichtung nach Anspruch 9, **dadurch gekennzeichnet, dass** Schmierfett in einer Öffnung der linken Endkappe bereitgestellt ist, aus der sich der zweite Abschnitt erstreckt, und Schmierfett in einer Öffnung der rechten Endkappe bereitgestellt ist, aus der sich der erste Abschnitt erstreckt.

11. Elektromotorprüfvorrichtung, **dadurch gekennzeichnet, dass** sie ein Thermostat, einen Drehmomentsensor, einen Servoelektromotor und eine Verbindungsvorrichtung nach einem der Ansprüche 1-10 umfasst, wobei
ein zu prüfender Elektromotor in dem Thermostat platziert wird und eine Ausgangswelle des zu prüfenden Elektromotors mit dem zweiten Abschnitt der Verbindungswelle der Verbindungsvorrichtung verbunden wird,
eine Seitenwand (11) des Thermostats mit einer Durchgangsöffnung versehen wird, wobei das Gehäuse der Verbindungsvorrichtung durch die Durchgangsöffnung hindurchgeht und gegen eine Innenwand der Durchgangsöffnung abgedichtet wird, und
der erste Abschnitt der Verbindungswelle mit dem Drehmomentsensor verbunden wird und der Drehmomentsensor mit dem Servoelektromotor verbunden wird.

12. Elektromotorprüfvorrichtung nach Anspruch 11, **dadurch gekennzeichnet, dass** eine Gummihülse auf der Innenwand der Durchgangsöffnung angeordnet wird und das Gehäuse gegen die Innenwand der Durchgangsöffnung mittels der Gummihülse abgedichtet wird.

## Revendications

1. Dispositif de liaison (2) pour essai de moteur électrique, **caractérisé en ce qu'**un moteur électrique (5) destiné à faire l'objet d'un essai est placé dans un thermostat (1), le dispositif de liaison pénètre dans une paroi latérale du thermostat et comprend un logement (21), un arbre de liaison et au moins deux joints d'étanchéité,
l'arbre de liaison (22) comprend une première section (221), une seconde section (222), et une section intermédiaire (223) située entre la première section et la seconde section, la première section, la seconde section et la section intermédiaire sont formées de façon monobloc,
la section intermédiaire est située à l'intérieur du logement, et la première section et la seconde section sont situées à l'extérieur du logement ;
les au moins deux joints d'étanchéité sont emmanchés sur une paroi périphérique extérieure de la section intermédiaire et sont en ajustement serré avec le logement, et au moins une cavité étanche est entourée conjointement par les au moins deux joints d'étanchéité (23), la paroi périphérique extérieure de la section intermédiaire et une paroi intérieure du logement, et est remplie avec de l'air comprimé pour supporter l'arbre de liaison ; et
la première section est reliée à un élément d'équipement externe d'essai de moteur électrique à l'extérieur d'un thermostat, et la seconde section est reliée au moteur électrique à l'intérieur du thermostat.

2. Dispositif de liaison de la revendication 1, **caractérisé en ce que** la section intermédiaire est pourvue d'une saillie (224) pour empêcher l'arbre de liaison de se déplacer axialement.

3. Dispositif de liaison de la revendication 2, **caractérisé en ce que** la saillie est formée de façon monobloc avec l'arbre de liaison et est près de la première section.

4. Dispositif de liaison de la revendication 1, **caractérisé en ce que** le nombre des joints d'étanchéité est de quatre, et les quatre joints d'étanchéité sont respectivement emmanchés sur les parois périphériques extérieures de deux extrémités de la section intermédiaire.

5. Dispositif de liaison de la revendication 1, **caractérisé en ce que** la paroi intérieure du logement est pourvue d'un évidement, l'évidement, les au moins deux joints d'étanchéité et la paroi périphérique extérieure de la section intermédiaire formant conjointement l'au moins une cavité étanche (24).

6. Dispositif de liaison de la revendication 1, **caractérisé en ce que** le dispositif de liaison comprend en outre une structure thermostatique, la structure thermostatique comprenant un passage d'écoulement entrant de fluide (213) et un passage d'écoulement sortant de fluide (214) prévus dans un corps principal du logement, et une douille (25) située à l'intérieur de la cavité étanche, au moins une partie de la cavité étanche étant couverte par une région d'espace formée par l'épaisseur de la paroi latérale, le passage d'écoulement entrant de fluide étant en communication avec une extrémité de la douille, et l'autre extrémité de la douille étant en communication avec le passage d'écoulement sortant de fluide.

7. Dispositif de liaison de la revendication 6, **caractérisé en ce que** la douille est emmanchée sur la périphérie de la section intermédiaire et est en ajustement serré avec le logement, et une surface extérieure de la douille est pourvue d'un canal d'écoulement (251) pour qu'un fluide s'écoule à travers celui-ci.

8. Dispositif de liaison de la revendication 7, **caractérisé en ce que** le canal d'écoulement est un canal d'écoulement en spirale.

9. Dispositif de liaison de l'une quelconque des revendications 1 à 8, **caractérisé en ce que** le logement comprend un corps principal (210), un chapeau d'extrémité gauche (211) et un chapeau d'extrémité droit (212),
dans lequel le chapeau d'extrémité gauche est relié au corps principal de façon fixe, le chapeau d'extrémité droit est relié au corps principal de façon fixe, le chapeau d'extrémité gauche est situé à l'intérieur du thermostat, et le chapeau d'extrémité droit est situé à l'extérieur du thermostat, et
la seconde section s'étend au-delà du chapeau d'extrémité gauche, et la première section s'étend au-delà du chapeau d'extrémité droit.

10. Dispositif de liaison de la revendication 9, **caractérisé en ce que** de la graisse de lubrification est prévue dans un trou du chapeau d'extrémité gauche pour que la seconde section s'étende à partir de celui-ci, et de la graisse de lubrification est prévue dans un trou du chapeau d'extrémité droit pour que la première section s'étende à partir de celui-ci.

11. Dispositif d'essai de moteur électrique, **caractérisé en ce qu'**il comprend un thermostat, un capteur de couple, un servo-moteur électrique, et un dispositif de liaison de l'une quelconque des revendications 1 à 10, dans lequel
un moteur électrique destiné à faire l'objet d'un essai est placé dans le thermostat, et un arbre de sortie du moteur électrique destiné à faire l'objet d'un essai est relié à la seconde section de l'arbre de liaison du dispositif de liaison,
une paroi latérale (11) du thermostat est pourvue d'un trou de passage, le logement du dispositif de liaison passant à travers le trou de passage et étant rendu étanche contre une paroi intérieure du trou de passage, et
la première section de l'arbre de liaison est reliée au capteur de couple, et le capteur de couple est relié au servo-moteur électrique.

12. Dispositif d'essai de moteur électrique de la revendication 11, **caractérisé en ce qu'**un manchon en caoutchouc est agencé sur la paroi intérieure du trou de passage, et le logement est rendu étanche contre la paroi intérieure du trou de passage au moyen du manchon en caoutchouc.
